# EUROPEAN PATENT APPLICATION

(11) **EP 3 327 893 A1**
(43) Date of publication of application: **30.05.2018**
(21) Application number: 16830702.3
(22) Date of filing: 27.06.2016
(51) Int. Cl.: H02J 7/02, H02J 7/00, H05K 7/20, B60R 16/03, B60H 1/00

(54) **WIRELESS CHARGING DEVICE FOR VEHICLE**

(30) Priority: 24.07.2015 KR 20150104848
(71) Applicant: LG Innotek Co., Ltd., Seoul, 04637 (KR)
(72) Inventor: KWON, Yong Il, Seoul 04637 (KR); KIM, Seung Tae, Seoul 04637 (KR); LEE, Jae Kyu, Seoul 04637 (KR)
(74) Representative: Zardi, Marco
(86) International application number: PCT/KR2016/006828
(87) International publication number: WO 2017/018669

(57) **Abstract**

The present invention provides a wireless power transmitting device comprising: a power transmission unit which transmits a wireless power signal to a subject being charged; a feedback reception unit which receives a feedback signal transferred from the subject being charged, and controls the power transmission unit; and a cooling unit which is positioned on the periphery of the power transmission unit, and absorbs heat.

## Description

### [Technical Field]

Embodiments relate to a wireless charging device, and more particularly, to a wireless charging device mountable in a vehicle.

### [Background Art]

Wireless charging is a technique of charging a battery by causing current to flow through electromagnetic induction. In this technique, a magnetic field generated in a primary coil of a charging pad induces current in a secondary coil of the battery part. This technique is suitable for portable communication devices and electric vehicles that require a large capacity battery. In addition, with this technique, contacts are not exposed to the outside. Accordingly, there is almost no risk of electric leakage and poor charging caused by the wired charging technique may be prevented.

As wireless charging technology has become entrenched, various charging pads have been developed to provide wireless charging power signals. Generally, a charging pad includes a coil or antenna for transmitting a wireless charging power signal, and a substrate including a circuit unit for supplying a power signal to the coil or antenna according to the wireless charging technology and controlling the power signal.

Wireless charging devices may be used not only in buildings such as a home or business, but also in a vehicle. A wireless charging device mounted in a vehicle may be used to charge the portable devices of the occupants including the driver. When the wireless charging device is operatively connected with electronic devices (for example, a control system, a vehicle navigation system, an audio device, a radio device, etc.) mounted in the vehicle, it may provide information such as the operation state of the wireless charging device to the occupants.

When the wireless charging device is mounted in or connected to a vehicle and wirelessly charges a portable device, heat may be generated in a wireless charging transmitter and a wireless charging receiver when the portable device performs the wireless charging operation. Heat generated inside the vehicle may damage the interior of the vehicle or threaten the safety of passengers. Accordingly, a means to suppress heat that may be generated when the wireless charging operation is performed in the vehicle or to remove the generated heat from the inside of the vehicle is required.

### [Disclosure]

### [Technical Problem]

Embodiments provide a method and apparatus for connecting a wireless power transmission/reception device for transmitting/receiving a wireless power signal for wireless charging with another system.

In addition, embodiments provide a method and apparatus for linking a wireless power transmission device mounted in a vehicle to an in-vehicle electronic control system.

In addition, embodiments provide a method and apparatus for effectively controlling heat generated in a wireless charging operation performed in a vehicle.

The technical objects that can be achieved through the embodiments are not limited to what has been particularly described hereinabove and other technical objects not described herein will be more clearly understood by persons skilled in the art from the following detailed description.

### [Technical Solution]

In one embodiment, a wireless power transmission device may include a power transmission unit configured to transmit a wireless power signal to an object-to-be-charged, a feedback reception unit configured to receive a feedback signal transmitted from the object-to-be-charged and to control the power transmission unit, and a cooling unit positioned around the power transmission unit to absorb heat.

The cooling unit may operate when a temperature recognized by the feedback reception unit exceeds a predetermined range.

The cooling unit may include a plurality of thermoelectric elements including an n-type thermoelectric element and a p-type thermoelectric element.

The plurality of thermoelectric elements may have a heat absorbing area and a heat radiating area varying depending on a direction of a current supplied to the n-type thermoelectric element and the p-type thermoelectric element.

The feedback reception unit may output state information on wireless charging using a short-range communication scheme.

The state information on the wireless charging may include at least one of a state of connection with the object-to-be-charged, a charging level of the object-to-be-charged, or a temperature of the object-to-be-charged.

The short-range communication scheme may be at least one of Bluetooth, Near Field Communication (NFC), ZigBee, or Wi-Fi.

The wireless charging may be performed in at least one of a magnetic induction scheme and a magnetic resonance scheme.

In another embodiment, a control system for a vehicle operatively connected with a wireless power transmission device for wirelessly charging a portable device of an occupant may include a power supply configured to supply power to the wireless power transmission device, an air conditioning unit configured to condition air through at least one of heating, ventilation or cooling of the vehicle and connected to the wireless power transmission device, a controller configured to control the power supply and the air conditioning unit according to temperature information, and a display unit configured to display the temperature information and a control result of the controller.

The control system may further include a temperature sensing unit configured to sense a temperature of a space in which the portable device and the wireless power transmission device are located and to transmit the sensed temperature to the controller as the temperature information.

The control system may further include a state reception unit configured to receive the temperature information from at least one of the portable device or the wireless power transmission device.

The temperature information may be transmitted using a short-range communication scheme including at least one of Bluetooth, Near Field Communication (NFC), ZigBee, or Wi-Fi.

The controller may transmit a signal for stopping the wireless charging to at least one of the power supply, the wireless power transmission device, or the portable device, based on the temperature information.

The controller may automatically activate the air conditioning unit when the temperature information is out of a preset range.

When wireless charging is started, the controller may check whether the air conditioning unit is in operation, wherein the controller may switch the air conditioning unit to a standby mode when the air conditioning unit is not in operation.

The wireless charging may be performed in at least one of a magnetic induction scheme and a magnetic resonance scheme.

The above-described aspects of the present disclosure are merely a part of preferred embodiments of the present disclosure. Those skilled in the art will derive and understand various embodiments reflecting the technical features of the present disclosure from the following detailed description of the present disclosure.

### [Advantageous Effects]

The method and apparatus according to the embodiments have the following effects.

According to the embodiments, devices for wireless charging may be operatively connected with an external system, and therefore control of wireless charging may be facilitated.

According to the embodiments, risks raised by heat that may be generated during the wireless charging operation performed in a vehicle may be eliminated, and therefore occupant safety may be secured.

It will be appreciated by those skilled in the art that that the effects that can be achieved through the embodiments of the present disclosure are not limited to those described above and other advantages of the present disclosure will be more clearly understood from the following detailed description.

### [Description of Drawings]

The accompanying drawings, which are included to provide a further understanding of the disclosure and are incorporated in and constitute a part of this application, illustrate embodiments of the disclosure and together with the description serve to explain the principle of the disclosure. It is to be understood, however, that the technical features of the present disclosure are not limited to the specific drawings, and the features disclosed in the drawings may be combined with each other to constitute a new embodiment.
FIG. 1 illustrates a first wireless charging system for vehicles.
FIG. 2 illustrates a second wireless charging system for vehicles.
FIG. 3 illustrates a third wireless charging system for vehicles.
FIG. 4 illustrates an example in which the first to third wireless charging systems for vehicles are mounted in a vehicle.
FIG. 5 illustrates a wireless charging transmission device applicable to the first to third wireless charging systems for vehicles.
FIG. 6 illustrates connection between the wireless charging transmission device illustrated in FIG. 5 and an in-vehicle air conditioning unit.
FIGs. 7A and 7B illustrate the cooling unit illustrated in FIG. 5.

### [Detailed Description]

Hereinafter, an apparatus and various methods to which embodiments of the present disclosure are applied will be described in detail with reference to the drawings. As used herein, the suffixes "module" and "unit" are added or used interchangeably to facilitate preparation of this specification and are not intended to suggest distinct meanings or functions.

In the description of the embodiments, it is to be understood that, when an element is described as being "on" or "under" another element, it can be directly "on" or "under" another element or can be indirectly formed such that one or more other intervening elements are also present between the two elements. The expression "on" or "under" may represent not only an upward direction but also a downward direction with respect to one element.

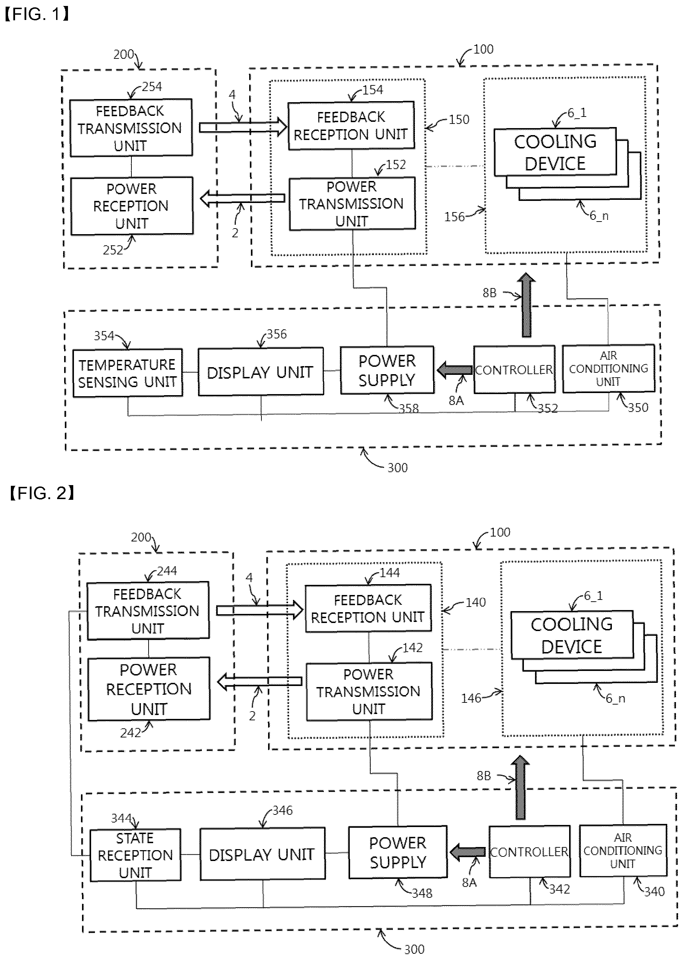

FIG. 1 illustrates a first wireless charging system for vehicles.

As shown in the figure, the first wireless charging system for vehicles may include a wireless power transmission device 100, a wireless power reception device 200, and a vehicle control system 300.

The wireless power transmission device 100 is configured to transmit a wireless power signal 2 and may be embedded in a vehicle or designed to be optionally connected to the vehicle by an occupant. The wireless power transmission device 100 may include a charging unit 150, which includes a power transmission unit 152 for transmitting the wireless power signal 2 to the wireless power reception device 200 and a feedback reception unit 154 for receiving a feedback signal 4 from the wireless power reception device 200, and a cooling unit 156 disposed around the power transmission unit 152 to absorb heat. The cooling unit 156 may include a plurality of cooling devices 6_1,..., 6_n. The feedback reception unit 154 may control the operation of the power transmission unit 152 and the cooling unit 156 after recognizing the feedback signal 4. The wireless power transmission device 100 may generate the wireless power signal 2 through magnetic induction or magnetic resonance.

The wireless power reception device 200 is a device that receives the wireless power signal 2 from the wireless power transmission device 100. For example, the wireless power reception device 200 may be a portable terminal or the like used by a vehicle occupant. The wireless power reception device 200 may include a power reception unit 252 configured to receive the wireless power signal 2 from the wireless power transmission device 100 and a feedback transmission unit 254 configured to feedback information such as the connection state, the charging level and the temperature, which need to be checked during the process of wireless charging, to the wireless power transmission device 100.

The wireless power transmission device 100 may be connected to a system in a vehicle to receive power.

The vehicle control system 300 may include a power supply 352 configured to supply power to the wireless power transmission device 100, an air conditioning unit 350 configured to condition the air through at least one of heating, ventilation or cooling of the vehicle and connected to the wireless power transmission device 100, a temperature sensing unit 354 configured to sense the temperature of a space of the vehicle where the air conditioning unit 350, the wireless power transmission device 100 and the wireless power reception device 200 are located and to transmit the sensed temperature to a controller 352 as temperature information, a controller 352 configured to control the power supply 352 and the air conditioning unit 350 according to the temperature information, and a display unit 356 configured to display a control result of the controller 352 to the occupant.

The power supply 352 may be connected to a battery or a generator included in the vehicle to supply power required by the wireless power transmission device 100.

The display unit 356 may include a display interface included in the vehicle. The display unit 356 may display information such as radio broadcast and navigation according to operation mode, or display the progress of the wireless charging operation. For example, information related to the wireless charging operation shown by the display unit 356 may be transmitted from the wireless charging transmission device 100 or the wireless charging reception apparatus 200.

The temperature sensing unit 354 senses the temperature of the inside of the vehicle. For example, the temperature sensing unit 354 may automatically sense the temperature of the inside of the vehicle when the vehicle is started. Further, when the wireless power transmission device 100 starts wireless charging, the temperature sensing unit may sense the temperature of the inside of the vehicle. In addition, the temperature sensing unit 354 may provide information for controlling the air inside the vehicle, in operative connection with the air conditioning unit 350.

If wireless charging is performed in the vehicle and the temperature of the inside of the vehicle abnormally increases during wireless charging, the controller 352 may adjust the internal temperature of the vehicle using at least one of several methods. For example, the controller 352 may activate the air conditioning unit 350 in response to the temperature information received from the temperature sensing unit 354. When the temperature information is beyond a normal range, the controller 352 may control the power supply 358 to stop supplying power to the wireless charging transmission device 100 (8A). In addition, the controller 352 may control the wireless charging transmission device 100 (8B). In this case, the controller 352 may activate the cooling unit 156 included in the wireless charging transmission device 100, and control the power transmission unit 152 in the wireless charging transmission device 100 to stop transmitting the wireless power signal.

Further, when the temperature information is out of a preset range, the controller 352 may automatically activate the air conditioning unit 350. In addition, when wireless charging is started, the controller 352 may check whether the air conditioning unit 350 is in operation, and may switch the air conditioning unit 350 to a standby mode if the air conditioning unit 350 is not in operation.

When state information indicating that the wireless charging operation is not normally performed is input, the controller 358 may command the wireless power transmission device 100, the wireless power reception device 200, or both to stop the wireless charging operation in order to secure occupant safety.

When wireless charging is performed, the control unit 358 may monitor and control the vehicle control system 300. For example, when there is insufficient power available from the power supply 352, the controller 358 may control the power supply 352 not to supply power to the power transmission unit 152.

FIG. 2 illustrates a second wireless charging system for vehicles.

As shown in the figure, the first wireless charging system for vehicles may include a wireless power transmission device 100, a wireless power reception device 200, and a vehicle control system 300.

The wireless power transmission device 100 is configured to transmit a wireless power signal 2 and may be embedded in a vehicle or designed to be optionally connected to the vehicle by an occupant. The wireless power transmission device 100 may include a charging unit 140, which includes a power transmission unit 142 for transmitting the wireless power signal 2 to the wireless power reception device 200 and a feedback reception unit 144 for receiving a feedback signal 4 from the wireless power reception device 200, and a cooling unit 146 disposed around the power transmission unit 142 to absorb heat. The cooling unit 146 may include a plurality of cooling devices 6_1,..., 6_n. After recognizing the feedback signal 4, the feedback reception unit 144 may control the operation of the power transmission unit 152 and the cooling unit 146. The wireless power transmission device 100 may generate the wireless power signal 2 through magnetic induction or magnetic resonance.

The wireless power reception device 200 is a device that receives the wireless power signal 2 from the wireless power transmission device 100. For example, the wireless power reception device 200 may be a portable terminal or the like used by a vehicle occupant. The wireless power reception device 200 may include a power reception unit 242 configured to receive the wireless power signal 2 from the wireless power transmission device 100 and a feedback transmission unit 244 configured to feed back information such as the connection state, the charging level and the temperature, which need to be checked during the process of wireless charging, to the wireless power transmission device 100 through a feedback signal 4. Here, the feedback transmission unit 244 may send the temperature information obtained in the wireless charging process to the vehicle control system 300.

The feedback transmission unit 244 may transmit other information as well as the temperature information during the wireless charging process. For example, the feedback transmission unit 244 may send the feedback signal 4 to the vehicle control system 300 as well as the wireless charging transmission device 100. For example, in feeding back the state information about the wireless charging operation to the wireless charging transmission device 100, the feedback transmission unit 244 may use data formats which are used in wireless transmission schemes such as Near Field Communication (NFC), Bluetooth, Bluetooth Low Energy (BLE), and ZigBee. If the feedback signal 4 output by the feedback transmission unit 244 uses the aforementioned standardized wireless communication schemes, the vehicle control system 300 may receive the same data as the wireless charging transmission device 100 receives, via a state reception unit 344.

The wireless power transmission device 100 may be connected to a system in the vehicle to receive power.

The vehicle control system 300 may include a power supply 342 configured to supply power to the wireless power transmission device 100, an air conditioning unit 340 configured to condition the air through at least one of heating, ventilation or cooling of the vehicle and connected to the wireless power transmission device 100, a state reception unit 344 configured to receive the temperature information from the wireless power reception device 200, a controller 342 configured to control the power supply 342 and the air conditioning unit 340 according to the temperature information, and a display unit 346 configured to display a control result of the controller 342 to the occupant.

The power supply 342 may be connected to a battery or a generator included in the vehicle to supply power required by the wireless power transmission device 100.

The display unit 346 may include a display interface included in the vehicle. It may display information such as radio broadcast and navigation according to the operation mode, or display the progress of the wireless charging operation. For example, information related to the wireless charging operation shown by the display unit 346 may be transmitted from the wireless charging transmission device 100 or the wireless charging reception apparatus 200.

The state reception unit 344 may transmit the temperature information to the controller 342 such that the controller 342 may monitor the wireless charging operation. In addition, the state reception unit 344 may receive not only the temperature information but also information such as the connection state for wireless charging and the charging level of the load from the wireless power reception device 200. The state reception unit 344 may display the received information through the display unit 346 to allow the occupant to easily check the information. In addition, when the state reception unit 344 transfers the received information to the controller 342, the controller 342 may calculate the charging completion time and inform the occupant of the time.

The air conditioning unit 340 may include a temperature sensor (not shown) capable of sensing a temperature of the inside of the vehicle. For example, when the vehicle starts up, the temperature sensor may automatically sense the temperature of the inside of the vehicle and provide information for air conditioning inside the vehicle. The controller 342 may compare the temperature information transmitted from the state reception unit 344 with the temperature information transmitted from the temperature sensor in the air conditioning unit 340 to more accurately recognize the temperature of the inside of the vehicle.

If wireless charging is performed in the vehicle and the temperature of the inside of the vehicle abnormally increases during wireless charging, the controller 342 may adjust the internal temperature of the vehicle using at least one of several methods. For example, the controller 342 may activate the air conditioning unit 340 in response to the temperature information received from the state reception unit 344. When the temperature information is beyond a normal range, the controller 342 may control the power supply 348 to stop supplying power to the wireless charging transmission device 100 when the temperature information exceeds the normal range (8A). In addition, the controller 342 may control the wireless charging transmission device 100 (8B). In this case, the controller 342 may activate the cooling unit 146 included in the wireless charging transmission device 100, and control the power transmission unit 142 in the wireless charging transmission device 100 to stop transmitting the wireless power signal.

Further, when the temperature information is out of a predetermined range, the controller 342 may automatically activate the air conditioning unit 340. In addition, when wireless charging is started, the controller 342 may check whether the air conditioning unit 340 is in operation, and may switch the air conditioning unit 340 to a standby mode if the air conditioning unit 340 is not in operation.

When state information indicating that the wireless charging operation is not normally performed is input, the controller 348 may command the wireless power transmission device 100, the wireless power reception device 200, or both to stop the wireless charging operation in order to secure occupant safety.

When wireless charging is performed, the control unit 348 may monitor and control the vehicle control system 300. For example, when there is insufficient power available from the power supply 342, the controller 348 may control the power supply 342 not to supply power to the power transmission unit 142.

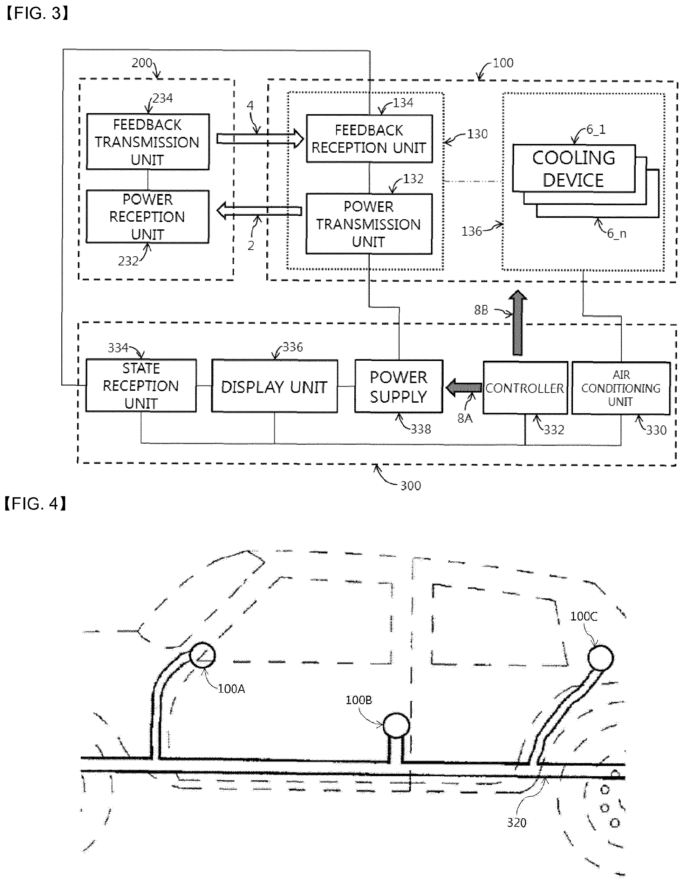

FIG. 3 illustrates a third wireless charging system for vehicles.

As shown in the figure, the first wireless charging system for vehicles may include a wireless power transmission device 100, a wireless power reception device 200, and a vehicle control system 300.

The wireless power transmission device 100 is configured to transmit a wireless power signal 2 and may be embedded in a vehicle or designed to be optionally connected to the vehicle by an occupant. The wireless power transmission device 100 may include a charging unit 130, which includes a power transmission unit 132 for transmitting the wireless power signal 2 to the wireless power reception device 200 and a feedback reception unit 134 for receiving a feedback signal 4 from the wireless power reception device 200, and a cooling unit 136 disposed around the power transmission unit 132 to absorb heat. The cooling unit 136 may include a plurality of cooling devices 6_1,..., 6_n. After recognizing the feedback signal 4, the feedback reception unit 134 may control the operation of the power transmission unit 132 and the cooling unit 136 and transmit the temperature information to the vehicle control system 300. The wireless power transmission device 100 may generate the wireless power signal 2 through magnetic induction or magnetic resonance.

The feedback receiver 134 may transmit other information as well as the temperature information during the wireless charging process. For example, the feedback reception unit 134 may send the information received from the wireless charging reception device 200 to the vehicle control system 300. For example, the wireless charging transmission device 100 and the vehicle control system 300 may be connected by wire to exchange information in the wireless charging process. In addition, in delivering the state information about the wireless charging operation to the vehicle control system 300, the feedback reception unit 134 may use data formats which are used in wireless transmission schemes such as Near Field Communication (NFC), Bluetooth, Bluetooth Low Energy (BLE), and ZigBee. If the information transmitted from the feedback receiver 134 uses the aforementioned standardized wireless communication schemes, the vehicle control system 300 may receive the same data via a state reception unit 334.

The wireless power reception device 200 is a device that receives the wireless power signal 2 from the wireless power transmission device 100. For example, the wireless power reception device 200 may be a portable terminal or the like used by a vehicle occupant. The wireless power reception device 200 may include a power reception unit 232 configured to receive the wireless power signal 2 from the wireless power transmission device 100 and a feedback transmission unit 234 configured to feed back information such as the connection state, the charging level and the temperature, which need to be checked during the process of wireless charging, to the wireless power transmission device 100 through a feedback signal 4.

The wireless power transmission device 100 may be connected to a system in the vehicle to receive power.

The vehicle control system 300 may include a power supply 332 configured to supply power to the wireless power transmission device 100, an air conditioning unit 330 configured to condition the air through at least one of heating, ventilation or cooling of the vehicle and connected to the wireless power transmission device 100, a state reception unit 334 configured to receive the temperature information from the wireless power reception device 200, a controller 332 configured to control the power supply 332 and the air conditioning unit 330 according to the temperature information, and a display unit 336 configured to display a control result of the controller 332 to the occupant.

The power supply 332 may be connected to a battery or a generator included in the vehicle to supply power required by the wireless power transmission device 100.

The display unit 336 may include a display interface included in the vehicle. It may display information such as radio broadcast and navigation according to the operation mode, or display the progress of the wireless charging operation. For example, information related to the wireless charging operation shown by the display unit 336 may be transmitted from the wireless charging transmission device 100 or the wireless charging reception apparatus 200.

The state reception unit 334 may transmit the temperature information to the controller 332 such that the controller 332 may monitor the wireless charging operation. In addition, the state reception unit 334 may receive not only the temperature information but also information such as the connection state for wireless charging and the charging level of the load from the wireless power reception device 200. The state reception unit 334 may display the received information through the display unit 336 to allow the occupant to easily check the information. In addition, when the state reception unit 334 transfers the received information to the controller 332, the controller 332 may calculate the charging completion time and inform the occupant of the time.

The air conditioning unit 330 may include a temperature sensor (not shown) capable of sensing a temperature of the inside of the vehicle. For example, when the vehicle is turned on, the temperature sensor may automatically sense the temperature of the inside of the vehicle and provide information for air conditioning inside the vehicle. The controller 332 may compare the temperature information transmitted from the state reception unit 334 with the temperature information transmitted from the temperature sensor in the air conditioning unit 330 to more accurately recognize the temperature of the inside of the vehicle.

If wireless charging is performed in the vehicle and the temperature of the inside of the vehicle abnormally increases during wireless charging, the controller 332 may adjust the internal temperature of the vehicle using at least one of several methods. For example, the controller 332 may activate the air conditioning unit 330 in response to the temperature information received from the state reception unit 334. When the temperature information is beyond a normal range, the controller 332 may control the power supply 338 to stop supplying power to the wireless charging transmission device 100 when the temperature information exceeds the normal range (8A). In addition, the controller 332 may control the wireless charging transmission device 100 (8B). In this case, the controller 332 may activate the cooling unit 136 included in the wireless charging transmission device 100, and control the power transmission unit 132 in the wireless charging transmission device 100 to stop transmitting the wireless power signal.

Further, when the temperature information is out of a predetermined range, the controller 332 may automatically activate the air conditioning unit 330. In addition, when wireless charging is started, the controller 332 may check whether the air conditioning unit 330 is in operation, and may switch the air conditioning unit 330 to a standby mode if the air conditioning unit 330 is not in operation.

When state information indicating that the wireless charging operation is not normally performed is input, the controller 338 may command the wireless power transmission device 100, the wireless power reception device 200, or both to stop the wireless charging operation in order to secure occupant safety.

When wireless charging is performed, the control unit 338 may monitor and control the vehicle control system 300. For example, when there is insufficient power available from the power supply 332, the controller 338 may control the power supply 332 not to supply power to the power transmission unit 132.

FIG. 4 illustrates an example in which the first to third wireless charging systems for vehicles are mounted in a vehicle.

As shown in the figure, a vehicle may include an air conditioning unit 320. In addition, wireless power transmission devices 100A, 100B, and 100C may be located in an internal space of the vehicle to which the air conditioning unit 320 is connected. The air conditioning unit 320 of the vehicle may be formed in front of the driver's seat and the front passenger's seat in the vehicle, around the console box between the driver's seat and the passenger's seat, or on a door or the back of the rear seat. The wireless power transmission devices 100A, 100B, and 100C may be located adjacent to the air conditioning unit 320 positioned inside the vehicle.

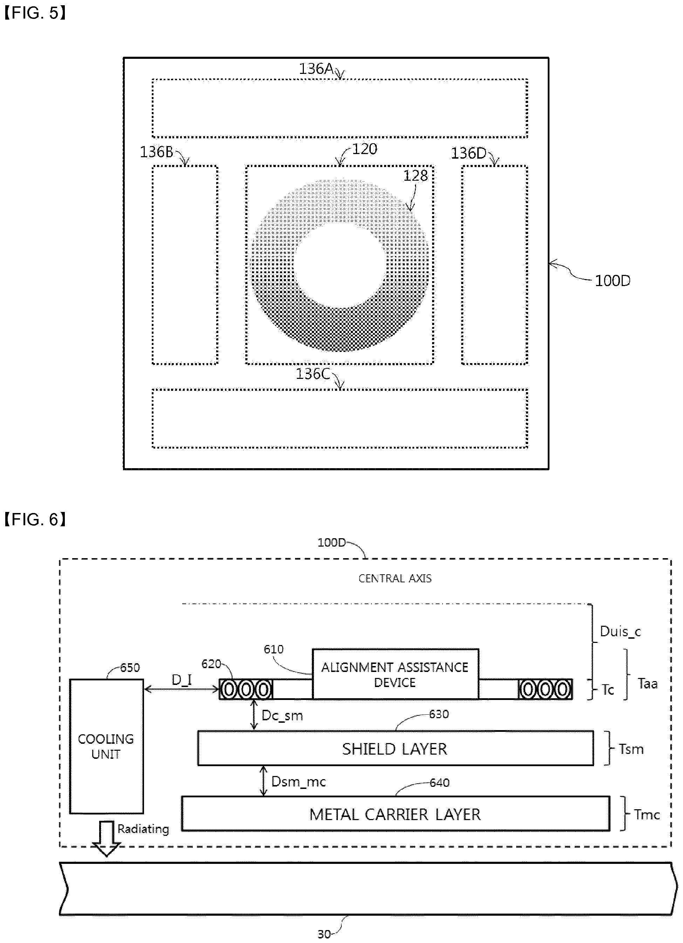

FIG. 5 illustrates a wireless charging transmission device applicable to the first to third wireless charging systems for vehicles.

As shown in the figure, the wireless charging transmission device 100D may include a charging unit 120, which may include a coil 128 for transmitting a wireless power signal, and at least one cooling unit 136A, 136B, 136C, 136D. Here, the cooling units 136A, 136B, 136C, and 136D may be spaced apart from the charging unit 120 by a predetermined distance to avoid interference with the charging unit 120.

While the at least one cooling unit 136A, 136B, 136C, and 136D is illustrated in FIG. 5 as surrounding the charging unit 120, it may be located only on two sides of the charging unit 120 or only on one side of the charging unit 120.

Although not shown, the cooling units 136A, 136B, 136C, and 136D may be located under the charging unit 120. The positional relationship between the cooling units 136A, 136B, 136C, and 136D and the charging unit 120 may be changed according to design.

FIG. 6 illustrates connection between the wireless charging transmission device 100D illustrated in FIG. 5 and an in-vehicle air conditioning unit 30.

As shown in the figure, the wireless charging transmission device 100D may be located on the air conditioning unit 30. The wireless charging transmission device 100D may include a cooling unit 650. The cooling unit 650 may radiate the absorbed heat to the air conditioning unit 30. The cooling unit 650 may include a fan (not shown) to enhance heat radiation.

The interface of the wireless charging transmission device 100D may include an alignment assistance device 610, a primary coil 620, and a shield layer 630, which are positioned symmetrically with respect to a central axis. In addition, a metal carrier layer 640 may be positioned symmetrically with respect to the central axis in order to increase the transmission efficiency of power signals. In one embodiment, the alignment assistance device 610 may include ferrite and magnets. A wireless charging reception device may also include an alignment assistance device corresponding to the alignment assistance device 610. For example, it may include ferrite, a magnet, and metal that magnetically react with the alignment assistance device 610.

The thicknesses of the alignment assistance device 610, the primary coil 620, the shield layer 630, and the metal carrier layer 640 and the spacing between the respective elements may be determined to increase the transmission efficiency of the power signal. For example, the thickness Taa of the alignment assistance device 610 may be in the range of 1.45 to 1.55 millimeters (mm), the thickness Tc of the primary coil 620 may be in the range of 0.4 to 0.5 mm, the thickness Tsm of the metal carrier layer 630 may be in the range of 0.9 to 1.1 mm, and the thickness Tmc of the metal carrier layer 640 may be in the range of 0.7 to 1.2 mm. The distance Duis_c from the surface of the reception device to the primary coil 620 may be in the range of 1.45 to 1.65 mm, the distance Dc_sm between the primary coil 620 and the shield layer 630 may be in the range of 0.05 to 0.1 mm, and the distance Dsm_mc between the shield layer 630 and the metal carrier layer 640 may be in the range of 0.05 to 0.1 mm.

The primary coil 620 and the cooling unit 650 may be separated by a distance D_I so as to suppress interference therebetween. For example, the distance D_I may depend on the magnitude of the power that may be output by the primary coil 620.

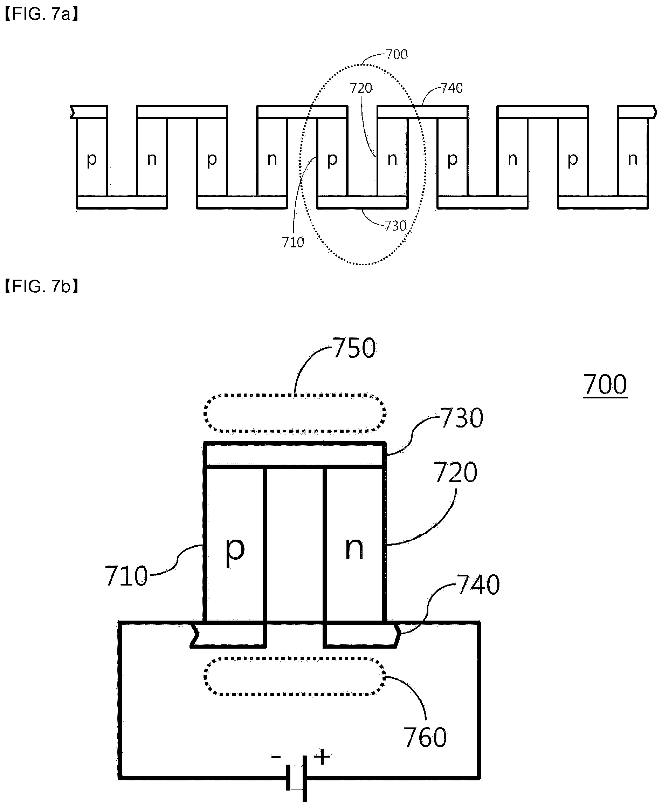

FIGs. 7A and 7B illustrate the cooling unit illustrated in FIG. 5.

Referring to FIG. 7A, the cooling unit may include a plurality of cooling devices 700. The plurality of cooling devices 700 may be arranged in a line or a matrix. The arrangement of the plurality of cooling devices 700 may be changed according to the design purpose.

A cooling device 700 is a module configured to perform a cooling function by implementing the Peltier effect according to application of power by arranging thermoelectric semiconductor elements 710 and 720 between substrates 730 and 740 facing each other. The cooling device 700 may include a first substrate 730 and a second substrate 740, which face each other, and a first semiconductor element 710 and a second semiconductor element 720, which are arranged between the first substrate 730 and the second substrate 740 and electrically connected to each other. In this case, the first semiconductor element 710 may be configured as a P-type semiconductor, and the second semiconductor element 720 may be configured as an N-type semiconductor. The first semiconductor element 710 and the second semiconductor element 720 may be connected to a metal electrode (not shown) to operate according to a current applied thereto.

Referring to FIG. 7B, a heat absorbing area 750 may be formed on the first substrate 730 when current is supplied to the first semiconductor element 710 and the second semiconductor element 720. The heat absorbed by the first substrate 730 may be transferred to the second substrate 740 via the first semiconductor element 710 and the second semiconductor element 720. A heat radiating area 760 may be formed on the second substrate 740.

Referring to FIGs. 7A and 7B, the thermoelectric phenomenon refers to reversible and direct energy conversion between thermal energy and electric energy, and is caused by movement of electrons or holes and heat transfer within a material due to a difference in temperature. The thermoelectric phenomenon may be divided into the Seebeck effect and the Peltier effect. The cooling device 700 uses the Peltier effect. When both ends of two different metal wires are joined together and current is applied thereto, heat is generated at one joint portion and heat absorption occurs at the other joint portion. Heat generation and heat absorption may occur on the opposite portions depending on the direction of current. In FIG. 7B, when the direction of the current applied to the first semiconductor element 710 and the second semiconductor element 720 is reversed, the heat absorbing area 750 and the heat generating area 760 may be switched.

When a wireless charging transmission device is connected to a closed internal space such as a vehicle and users wirelessly charge their portable terminals or the like, the temperature of the closed internal space may be increased due to heat generated in the process of wireless charging. This issue may be solved by lowering the temperature of the closed internal space using the wireless charging transmission device including the cooling device. Further, when the wireless charging transmission device, the wireless charging reception device, or the in-vehicle control system that supplies power to the wireless charging transmission device is operatively connected with the vehicle, wireless charging may be controlled using the temperature information.

It is apparent to those skilled in the art that the present disclosure can be embodied in specific forms other than those set forth herein without departing from the spirit and essential characteristics of the present disclosure.

Therefore, the above embodiments should be construed in all aspects as illustrative and not restrictive. The scope of the disclosure should be determined by the appended claims and their legal equivalents, and all changes coming within the meaning and equivalency range of the appended claims are intended to be embraced therein.

## Claims

1. A wireless power transmission device comprising:
a power transmission unit configured to transmit a wireless power signal to an object-to-be-charged;
a feedback reception unit configured to receive a feedback signal transmitted from the object-to-be-charged and to control the power transmission unit; and
a cooling unit positioned around the power transmission unit to absorb heat.

2. The wireless power transmission device according to claim 1, wherein the cooling unit operates when a temperature recognized by the feedback reception unit exceeds a predetermined range.

3. The wireless power transmission device according to claim 1, wherein the cooling unit comprises a plurality of thermoelectric elements including an n-type thermoelectric element and a p-type thermoelectric element.

4. The wireless power transmission device according to claim 3, wherein the plurality of thermoelectric elements has a heat absorbing area and a heat radiating area varying depending on a direction of a current supplied to the n-type thermoelectric element and the p-type thermoelectric element.

5. The wireless power transmission device according to claim 1, wherein the feedback reception unit outputs state information on wireless charging using a short-range communication scheme.

6. The wireless power transmission device according to claim 5, wherein the state information on the wireless charging comprises at least one of a state of connection with the object-to-be-charged, a charging level of the object-to-be-charged, or a temperature of the object-to-be-charged.

7. The wireless power transmission device according to claim 5, wherein the short-range communication scheme is at least one of Bluetooth, Near Field Communication (NFC), ZigBee, or Wi-Fi.

8. The wireless power transmission device according to claim 1, wherein the wireless charging is performed in at least one of a magnetic induction scheme and a magnetic resonance scheme.

9. A control system for a vehicle operatively connected with a wireless power transmission device for wirelessly charging a portable device of an occupant, the vehicle control system comprising:
a power supply configured to supply power to the wireless power transmission device;
an air conditioning unit configured to condition air through at least one of heating, ventilation or cooling of the vehicle and connected to the wireless power transmission device;
a controller configured to control the power supply and the air conditioning unit according to temperature information; and
a display unit configured to display the temperature information and a control result of the controller.

10. The control system according to claim 9, further comprising:
a temperature sensing unit configured to sense a temperature of a space in which the portable device and the wireless power transmission device are located and to transmit the sensed temperature to the controller as the temperature information.

11. The control system according to claim 9, further comprising:
a state reception unit configured to receive the temperature information from at least one of the portable device or the wireless power transmission device.

12. The control system according to claim 11, wherein the temperature information is transmitted using a short-range communication scheme comprising at least one of Bluetooth, Near Field Communication (NFC), ZigBee, or Wi-Fi.

13. The control system according to claim 11, wherein the controller transmits a signal for stopping the wireless charging to at least one of the power supply, the wireless power transmission device, or the portable device, based on the temperature information.

14. The control system according to claim 9, wherein the controller automatically activates the air conditioning unit when the temperature information is out of a preset range.

15. The control system according to claim 9, wherein, when wireless charging is started, the controller checks whether the air conditioning unit is in operation,
wherein the controller switches the air conditioning unit to a standby mode when the air conditioning unit is not in operation.

16. The control system according to claim 9, wherein the wireless charging is performed in at least one of a magnetic induction scheme and a magnetic resonance scheme.

17. The control system according to claim 9, wherein the wireless power transmission device comprises:
a power transmission unit configured to transmit a wireless power signal to the portable device;
a feedback reception unit configured to receive a feedback signal transmitted from the portable device and to control the power transmission unit; and
a cooling unit positioned around the power transmission unit to absorb heat.

18. The control system according to claim 17, wherein the cooling unit operates when the temperature information exceeds a predetermined range.

19. The control system according to claim 17, wherein the cooling unit comprises a plurality of thermoelectric elements including an n-type thermoelectric element and a p-type thermoelectric element.

20. The control system according to claim 17, wherein the plurality of thermoelectric elements has a heat absorbing area and a heat radiating area varying depending on a direction of a current supplied to the n-type thermoelectric element and the p-type thermoelectric element.
